# EUROPEAN PATENT SPECIFICATION

(11) **EP 1 724 601 B1**
(45) Date of publication and mention of the grant of the patent: **30.01.2008**
(21) Application number: 06008665.9
(22) Date of filing: 26.04.2006
(51) Int. Cl.: G01S 1/00, G01S 5/14

(54) **Positioning apparatus and positioning method**
Positionierungsvorrichtung und Positionierungsverfahren
Appareil et procédé de positionnement

(30) Priority: 11.05.2005 JP 2005138093
(43) Date of publication of application: 22.11.2006
(73) Proprietor: Seiko Epson Corporation, Shinjuku-ku, Tokyo 163-0811 (JP)
(72) Inventor: Muto, Nobuo, Suwa-shi Nagano-ken 392-8502 (JP)
(74) Representative: HOFFMANN EITLE

(56) References cited:
- WO-A-20/04086077
- US-A- 5 610 984
- US-A1- 2003 207 681
- US-B1- 6 292 748
- AKOPIAN D ET AL: "A fast matched filter in time domain" POSITION LOCATION AND NAVIGATION SYMPOSIUM, 2004. PLANS 2004 MONTEREY, CA, USA 26-29 APRIL 2004, PISCATAWAY, NJ, USA,IEEE, US, 26 April 2004 (2004-04-26), pages 455-460, XP010768908 ISBN: 0-7803-8416-4

## Description

The present invention relates to a positioning apparatus and a positioning method which use positioning standard codes from positioning satellites.

Conventionally, positioning systems for positioning a current position of each GPS (Global Positioning System) receiver using a satellite navigation system such as GPS have been used.

Such GPS receiver receives a C/A (Clear and Acquisition or Coarse and Access) code, which is one of the pseudo randomnoise codes (hereinafter, referredtoasPN (Pseudo random Noise code)) putted on radio waves from GPS satellites (hereinafter, referred to as satellite radio waves), based on satellite information indicating a GPS satellite orbit (rough satellite orbit information: almanac, accurate orbit information: ephemeris). The C/A code is a code serving as a positioning standard.

The GPS receiver then identifies which GPS satellite transmits the C/A code, and calculates the distance (pseudo distance) between the GPS satellite and the GPS receiver based on the time at which the C/A code is transmitted and the time at which it is received. The GPS receiver then positions the position of the GPS receiver based on the pseudo distance of three or more of GPS satellites and the position of each GPS satellite on the satellite orbit (e.g., JP-A-10-339772).

Here, since the above-mentioned satellite radio waves are subjected to PSK modulation by PN code such as the C/A code, spectral width expands. This causes degradation of signal to noise ratio (hereinafter, referred to as SNR (Signal to Noise Ratio)) of satellite radio waves, making it difficult to extract the C/A code.

Accordingly, the GPS receiver receives C/A codes from the identical GPS satellite multiple times, and then integrates the sampling results of the C/A codes, thereby improving the SNR. Hereinafter, integration of the sampling results is simply referred to as integration. In addition, integration of codes and integration of the sampling results of codes are identical actions.

However, since a C/A code is repeatedly transmitted for every 1 msec (ms), it takes 20 msec (ms) to receive it 20 times. This develops a problem that it requires a certain time determined by the transmission interval period of the C/A code to integrate the number of times required for extracting the C/A code.

US 6,292,748 B1 discloses a method for minimizing time error that uses a drift-susceptible time clock at the receiver carried by an asset to be tracked in a high-accuracy reduced-order GPS asset localization system. Long-term accuracy of the time clock is maintained by periodically re-synchronizing the clock with the master GPS time clock so that absolute asset time clock errors are kept below a known limit over the wide temperature ranges expected in the asset tracking application. This is accomplished with only a short GPS signal reception time; i.e., GPS frame synchronization and time-stamp decoding are not needed, and the asset position ambiguity associated with using GPS data-bit or code-bit edges as signal time references is eliminated.

US 5,610,984 discloses an optimal design of the SPS Receiver. The optimal SPS Receiver includes the digital filter with adjustable characteristics in each digital processing channel. The optimal design of the SPS Receiver is achieved by adjusting the filter characteristics of each digital filter to match the observed spectrum of the unknown W code satellite signals. The matching operation can be performed for each satellite channel with its own secret W code signal.

WO-A-2004/086077 discloses a method and apparatus for performing signal correlation. In one example, portions of a pseudorandom reference code are multiplied with portions of a repeating code of the digital signal to produce a plurality of inner products. The plurality of inner products are then integrated over a period less than a period of the repeating code to produce a corrlelation result with a broadened frequency response. In another example, the digital signal is correlated with a pseudorandom reference code toproduce a first correlation. The first and second correlations are then used to determine first and second signal delays. The frequency shift of the digital signal is computed using a difference between the first and second signal delays over time.

"A Fast Matched Filter in Time Domain" by Akopian and Agaian in Position Location and Navigation Symposium, pages 455-460, XP 010768908, ISBN 0-7803-8416-4 presents a fast matched filter algorithm in time domain. Matched filters compute correlation of signals for optimal detection of signals in noise, for extracting ranging measurements, synchronization, etc. The paper considers matched filters in the context of Global Positioning System (GPS) receivers. It is reported that the method outperforms conventional time domain method several times in arithmetic complexity, and is also competitive with transform domain techniques based on Fast Fourier Transform (FFT).

According to the present invention, there is provided a positioning apparatus for receiving a positioning standard code which is used as a standard of positioning from a positioning satellite, comprising: analysis assistance code generating means for generating a plurality of analysis assistance codes comprising replicas of a received positioning standard code for use in determining which positioning satellite corresponds to the received positioning standard code; positioning standard code identifying means for analyzing the positioning standard code and the analysis assistance codes, and identifying which positioning satellite corresponds to the positioning standard code, the positioning standard code identifying means comprising: means for integrating the received positioning standard code and the plurality of generated analysis assistance codes to generate an integrated result, and means for correlating the integrated result with a plurality of stored C/A codes to identify which positioning satellite corresponds to the received positioning standard code; and current position information generating means for generating current position information indicating a current position based on the identified result by the positioning standard code identifying means.

With this structure, the positioning apparatus can generate analysis assistance codes for analyzing the positioning standard codes using the analysis assistance code generating means.

The positioning apparatus can also analyze the positioning standard codes and the analysis assistance codes, and identify which positioning satellite corresponds to the positioning standard code using the positioning standard code identifying means.

Accordingly, when receiving the positioning standard codes once, the positioning apparatus can generate the number of analysis assistance codes required for identifying which positioning satellite corresponds to the positioning standard code based on the positioning standard code. This means that it is unnecessary for the positioning apparatus to receive the number of positioning standard codes required for identifying which positioning satellite corresponds to the positioning standard code. Accordingly, the positioning apparatus can integrate the sampling results of the positioning standard codes required for extracting the positioning standard codes without restrictions imposed by transmission interval period of the positioning standard codes.

This allows the positioning apparatus to integrate the number of times required for extracting the positioning standard codes without restrictions imposed by transmission interval period of the positioning standard codes.

The analysis assistance code generating means may be arranged to generate the analysis assistance codes so that the total number of the positioning standard codes and the analysis assistance codes equals the number required for identifying which positioning satellite corresponds to the positioning standard code.

With this structure, the analysis assistance code generating means can generate the sufficient number of analysis assistance codes required for identifying which positioning satellite corresponds to the positioning standard code.

The analysis assistance code generating means may be arranged to generate the analysis assistance codes within a range of delay in which the positioning standard code identifying means can identify standard unit code which is a standard unit configuring the positioning standard codes.

In order to identify which positioning satellite corresponds to the positioning standard code, it is necessary to integrate the standard unit codes with each other allocated at the identical position in the positioning standard codes.

With the structure above, the analysis assistance code generating means can generate the analysis assistance codes within a range of delay in which the analysis means can identify standard unit code which is a standard unit configuring the positioning standard codes. Thus, the positioning standard code identifying means can identify which positioning satellite corresponds to the positioning standard code reliably.

The analysis assistance code generating means may be arranged to generate the analysis assistance codes with respect to a part of the positioning standard code.

It is possible to determine which positioning satellite corresponds to the positioning standard code by analyzing a part of the positioning standard code, not all of it.

With the structure above, the analysis assistance code generating means can generate the analysis assistance codes with respect to a part of the positioning standard code. This allows the positioning standard code identifying means to reduce the time required for analysis and identify which positioning satellite corresponds to the positioning standard code.

The present invention also provides a positioning method, comprising an analysis assistance code generating step in which a positioning apparatus for receiving a positioning standard code which is used as a standard of positioning from a positioning satellite generates a plurality of analysis assistance codes comprising replicas of a received positioning standard code for use in determining which positioning satellite corresponds to the received positioning standard code; a positioning standard code identifying step in which the positioning apparatus analyzes the positioning standard code and the analysis assistance codes, and identifies which positioning satellite corresponds to the positioning standard code, the positioning standard code identifying step comprising: integrating the received positioning standard code and the plurality of generated analysis assistance codes to generate an integrated result, and correlating the integrated result with a plurality of stored C/A codes to identify which positioning satellite corresponds to the received positioning standard code; and a current position information generating step in which the positioning apparatus generates current position information indicating a current position based on the identified result by the positioning standard code identifying step.

With this method, it is possible to integrate the number of times required for extracting positioning standard codes without restrictions imposed by transmission interval period of positioning standard codes.

Embodiments of the invention will be described with reference to the accompanying drawings, wherein like numbers reference like elements.
Fig. 1 schematically shows a positioning system in an embodiment of the invention.
Fig. 2 schematically shows codes C1 and the like.
Fig. 3 schematically shows codes C1 and the like.
Fig. 4 schematically shows a main structure of a GPS apparatus.
Fig. 5 schematically shows a main hardware structure of a terminal.
Fig. 6 schematically shows a main software structure of the terminal.
Fig. 7 schematically shows a flowchart of an operation example of the positioning system.
Fig. 8 schematically shows a main structure of the GPS apparatus.
Fig. 9 schematically shows codes C1 and the like.

Hereinafter, with reference to the drawings, the preferred exemplary embodiments of the invention will be described in detail.

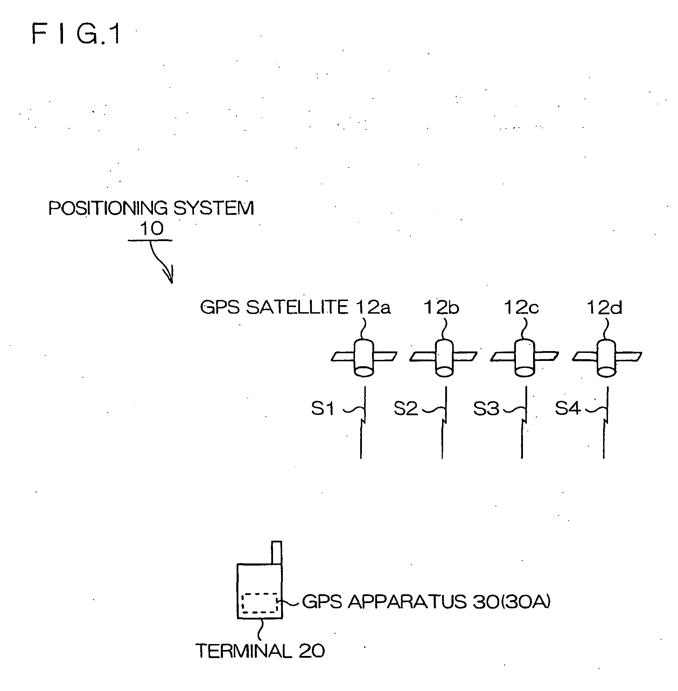

Fig. 1 schematically illustrates a positioning system 10 according to an embodiment of the invention.

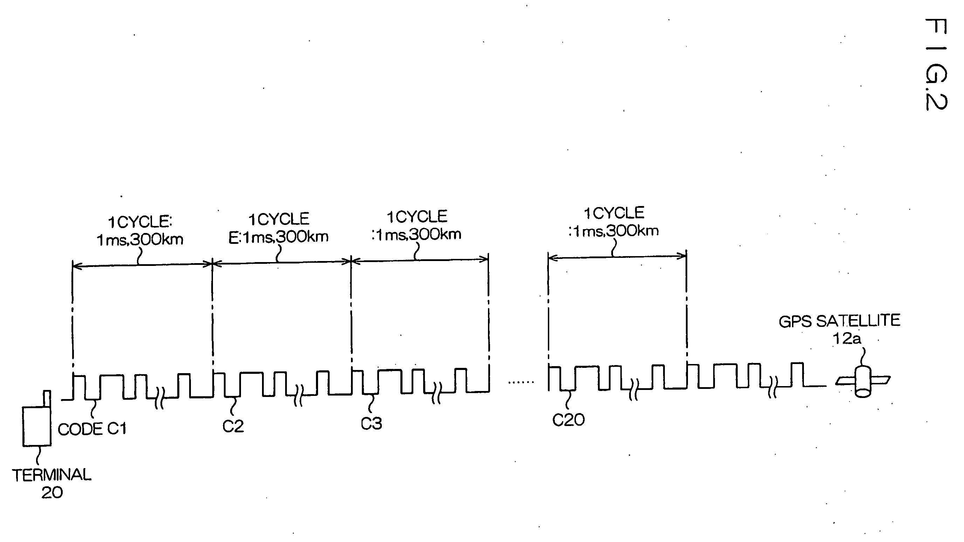

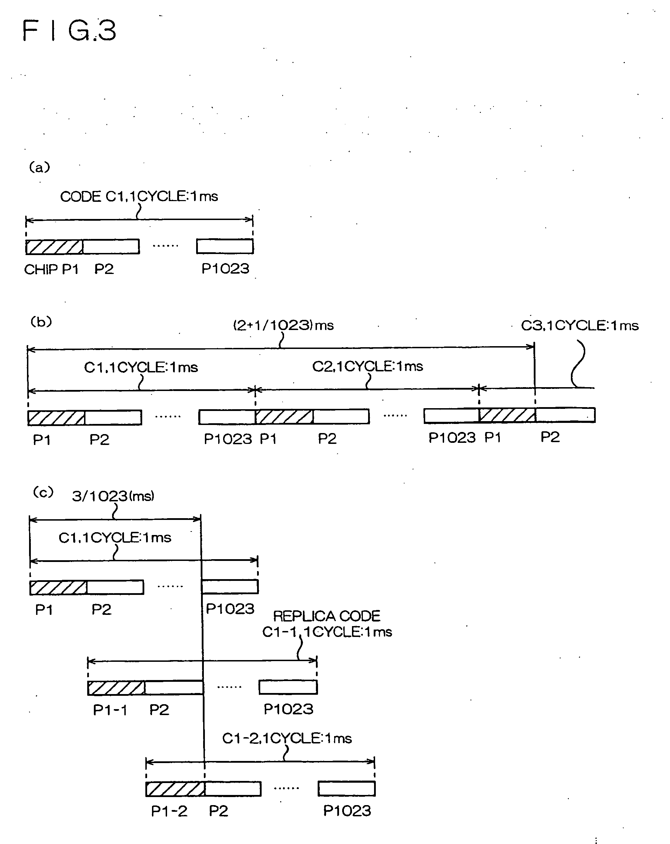

Figs. 2 and 3 schematically illustrate codes C1 and the like transmitted from GPS satellites 12a and the like.

As illustrated in Fig. 1, the positioning system 10 includes positioning satellites, such as the GPS satellites 12a, 12b, 12c and 12d. The GPS 12a and the like transmit radio waves S1, S2, S3 and S4, respectively, on which various codes are putted. One of these codes is C/A code. The codes C1 through C20 in Fig. 2 are C/A codes. The codes C1 through C20 are, for example, the identical code continuously transmitted from the GPS satellite 12a. For example, the code C1 is the C/A code transmitted prior to the code C2. The codes C1 and the like are an example of positioning standard code. The codes C1 and the like are also an example of a PRN (Pseudo Random Noise) code.

The positioning system 10 includes a terminal 20. The terminal 20 includes a GPS apparatus 30, and thus can receive the codes C1 and the like putted on the radio waves S1 and the like from the GPS satellites 12a and the like.

The terminal 20 then receives C/A codes from three or more of different GPS satellites 12a and the like, allowing positioning of a current position. The codes C1 and the like have a cycle of 1 msec (ms), which corresponds to the distance of 300 kilometers (km). The codes C1 and the like differ for each of the GPS satellites 12a and the like.

First, the terminal 20 identifies which GPS satellite corresponds to the code C1 or the like. Hereinafter, identification which GPS satellite corresponds to the code C1 or the like is referred to as extraction of the code C1 or the like or the C/A code. Next, the distance between each of the GPS satellites 12a and the like and the terminal 20 (hereinafter, referred to as pseudo distance) is calculated using light-speed propagation of the radio wave S1 on which codes are putted based on the difference between the time at which the codes C1 and the like are transmitted from each of the GPS satellites 12a and the like and the time at which the code C1 is received. A current position is then positioned based on the position of each of the GPS satellites 12a and the like on the satellite orbit at the current time and the above-mentioned pseudo distance.

It should be noted that four GPS satellites 12a and the like are illustrated in Fig. 1, however, the number of the GPS satellites 12a and the like may be three or five or more.

As illustrated in Fig. 3 (a), the code C1 is configured with 1,023 chips P1 through P1023. The chips P1 and the like are a standard unit, which configures the code C1 and indicates a numerical value of 0 or 1. The chips P1 and the like are an example of standard unit code.

In order to extract the C/A code, it is necessary to identify each chip P1 or the like is either 0 or 1. Hereinafter, identification of each chip P1 or the like being either 0 or 1 is referred to as identification of chip P1 and the like. The identification of chip P1 and the like is an example of analysis.

However, since the above-mentioned radio waves S1 and the like are subjected to PSK modulation by PN code such as C/A code, spectral width expands. This causes degradation of SNR, making it difficult to identify each chip P1 or the like.

Assuming that the GPS receiver receives the C/A code three times from the GPS satellite 12a, and integrates the sampling results of the C/A codes to improve the SNR, for example, as illustrated in Fig. 3 (b), it takes (2+1/1023) msec (ms) to identify the chip P1. This is because the code 1 should be received first, the code 2 should then be received, and the chip P1 section of the code C3 should then be received in order to receive the chip P1 three times. In other words, it takes a certain time determined by a cycle of the C/A code to receive the chip P1.

With the following structure, the terminal 20 in the embodiment of the invention can identify the chips P1 and the like without restrictions imposed by a certain time determined by the cycle of the C/A code.

### Structure of GPS Apparatus 30

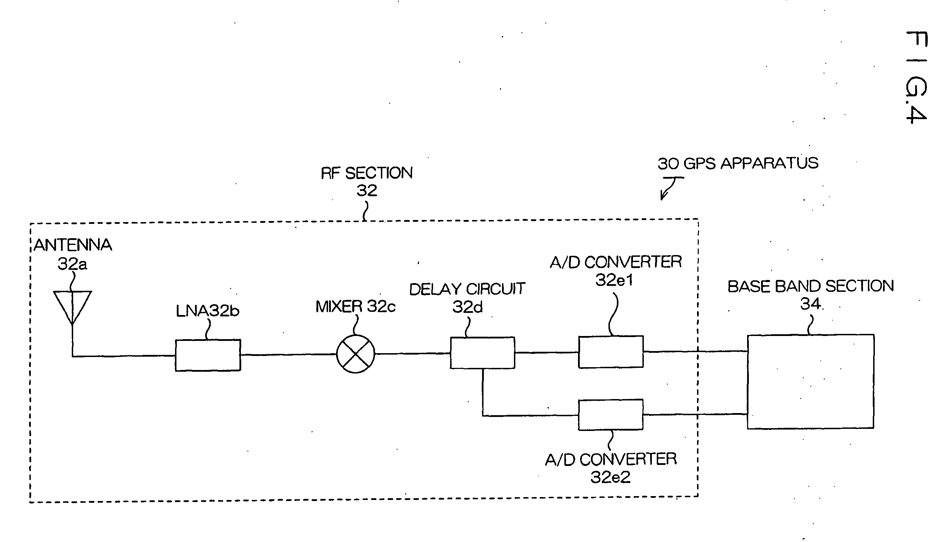

Fig. 4 schematically illustrates a structure of the GPS apparatus 30.

As illustrated in Fig. 4, the GPS apparatus 30 includes an RF section 32 and a base band section 34.

The RF section 32 receives C/A codes using an antenna 32a. An amplifier LNA32b amplifies the C/A codes. A mixer 32c then converts the frequency of the C/A codes. A delay circuit 32d including an IQ detector carries out IQ separation of the C/A codes. A/D converters 32e1 and 32e2 then converts the C/A codes subjected to IQ separation into digital signals, respectively.

The base band section 34 receives the C/A codes converted into digital signals from the RF section 32, samples and integrates each chip P1 or the like (see Fig. 3 (a)), and correlates with the C/A codes stored in the base band section 34, thereby identifying the received C/A codes.

### Main Hardware Structure of Terminal 20

Fig. 5 schematically illustrates a main hardware structure of the terminal 20.

As illustrated in Fig. 5, the terminal 20 includes a computer, which is equipped with a bus 22. A CPU (Central Processing Unit) 24, a storage apparatus 26, and the like are connected with the bus 22. The storage apparatus may be a RAM (Random Access Memory), a ROM (Read Only Memory), or the like.

An input apparatus 28, the GPS apparatus 30, a communication apparatus 36, a display apparatus 38, and a clock 40 are also connected with the bus 22.

### Main Software Structure of Terminal 20

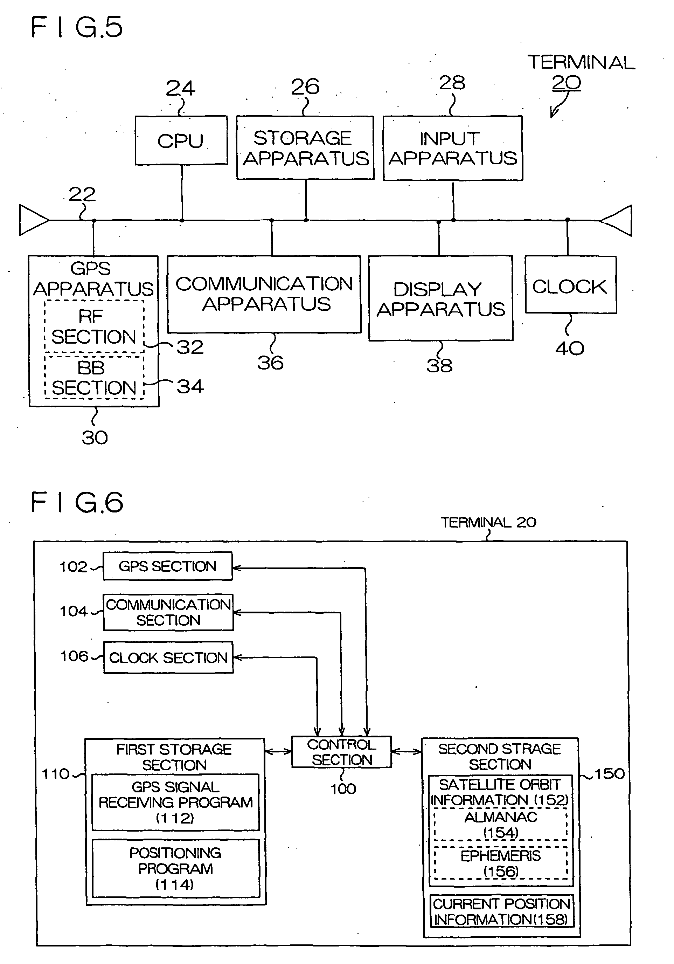

Fig. 6 schematically illustrates a main software structure of the terminal 20.
As illustrated in Fig. 6, the terminal 20 includes a control section 100 for controlling each section, a GPS section 102 corresponding to the GPS apparatus 30 in Fig. 5, a communication section 104 corresponding to the communication apparatus 36, a clock section corresponding to the clock 40, and the like.

The terminal 20 also includes a first storage section 110 for storing each program and a second storage section 150 for storing each pieces of information.

As illustrated in Fig. 6, the terminal 20 stores satellite orbit information 152 in the second storage section 150. The satellite orbit information 152 includes almanac 154 and ephemeris 156. The almanac 154 is information indicating a rough orbit of all GPS satellites 12a and the like. The ephemeris 156 is information indicating an accurate orbit of each of the GPS satellites 12a and the like. The terminal 20 uses the almanac 154 and the ephemeris 156 for positioning.

As illustrated in Fig. 6, the terminal 20 stores GPS signal receiving program 112 in the first storage section 110. The GPS signal receiving program 112 is a program that the control section 100 receives the C/A codes putted on the radio wave S1 from the GPS satellite 12a or the like using the GPS section 102.

The GPS apparatus 30 (see Fig. 4) instructed by the control section 100 first receives the C/A codes using the antenna 32a. For example, it is assumed that the code C1 is received from the GPS satellite 12a (see Fig. 3 (c)).

The code C1 is received by the delay circuit 32d passing through the LNA32b and the mixer 32c.

The delay circuit 32d generates replica codes C1-1 and C1-2, which are replicas of the code C1, based on the code C1 (see Fig. 3 (c)). The replica codes C1-1 and C1-2 are codes for identifying which GPS satellite corresponds to the code C1 by the base band section 34. In other words, the replica codes C1-1 and C1-2 are an example of analysis assistance codes. The delay circuit 32d is an example of analysis assistance code generating means.

As illustrated in Fig. 3 (c), the delay circuit 32d generates the replica code C1-1 having a 1-chip delay with respect to the code C1, and also generates the replica code C1-2 having a 1-chip delay with respect to the replica code C1-1.

The delay circuit 32d generates the replica codes C1-1 and the like so that the total number of the code C1 and the replica codes C1-1 and the like equals the number required for identifying which GPS satellite corresponds to the code C1 (hereinafter, referred to as the number required for code identification). The number required for code identification may be 20, for example, however, it is three herein for simplifying the description

The number required for code identification is not limited as in this embodiment, but may be changeable for each positioning based on the positioning conditions including receiving intensity of the radio waves S1 and the like, and PDOP (Position Dilution Of Precision) and the like.

The delay circuit 32d generates the code C1 and the replica codes C1-1 and the like within a range of delay in which the base band section 34 can identify the chip P1 and the like. For example, when the base band section 34 recognizes that the chips P1 and the like having a 1-chip delay, respectively, are, the chips at the identical position in the code C1 and the replica codes C1-1 and the like, the replica codes C1-1 and the like having a 1-chip delay, respectively, with respect to the code C1 are generated as illustrated in Fig. 3 (c).

The invention is not limited to this embodiment, for example, when the base band section 34 recognizes that the chips P1 and the like having a 2-chip delay, respectively, are the chips at the identical position in the code C1 and the replica codes C1-1 and the like, the replica codes C1-1 and the like having a 2-chip delay, respectively, with respect to the code C1 may be generated.

The delay circuit 32d also generates the replica codes C1-1 and the like with respect to a part of the code C1. It is not necessary to sample all chips P1 and the like in the code C1 but, for example, only 500 chips when the base band section 34 identifies which GPS satellite corresponds to the code C1. Accordingly, the delay circuit 32d replicates the code C1 in a range required for the base band section 34 to identify which GPS satellite corresponds to the code C1.

In Fig. 3 (c), all 1,023 chips are duplicated for convenience of the description.

The code C1 and the replica codes C1-1 and the like are subjected to IQ separation by the detector in the delay circuit 32d, and the results are transmitted to the A/D converters 32e1 and 32e2, respectively. As soon as being generated, the code C1 and the replica codes C1-1 and the like converted into digital signals are then transmitted to the base band section 34.

In the base band section 34, the code C1 and the replica codes C1-1 and the like are sampled in units of the chip P1 or the like, and the sampling results are integrated. The integrated sampling results and the C/A codes stored in the base band section 34 are then correlated, thereby identifying which GPS satellite corresponds to the received code C1. In other words, the base band section 34 is.an example of the positioning standard code identifying means.

Here, the replica codes C1-1 and the like are generated so as to have a 1-chip delay with respect to the code C1, respectively. Paying attention to the first chip P1 in the codes C1 and the like, it has a delay of 1/1023 msec (ms), respectively. Accordingly, the base band section 34 takes 3/1023 msec (ms) to receive the replica codes C1-1 and C1-2 after receiving the code C1.

If we receive the C/A code three times, and receive the respective chips P1 three times, for example, it takes (2+1/1023) msec (ms) as described above.

On the other hand, according to this embodiment, the base band section 34 takes extremely shorter time, only 3/1023 msec (ms) to receive the replica codes C1-1 and C1-2 after receiving the code C1.

The base band section 34 identifies which GPS satellite corresponds to the code 1, as well as the phase of the code C1.

As illustrated in Fig. 6, the terminal 20 stores positioning program 114 in the first storage section 110. The positioning program 114 is a program that the control section 100 generates current position information 158 indicating a current position based on the identified results by the GPS section 102. In other words, the positioning program 114 and the control section 100 are an example of the current position information generating means.

The terminal 20 is configured as described above.

As mentioned above, the terminal 20 can generate the replica codes C1-1 and the like.

The terminal 20 samples the code C1 and the replica codes C1-1 and the like, and can identify which GPS satellite corresponds to the code C1,

Accordingly, when receiving the code C1 once, the terminal 20 can generate the number of replica codes C1-1 and the like required for identifying which GPS satellite corresponds to the code C1 based on the code C1. This means that it is unnecessary for the terminal 20 to receive the number of codes C1 and the like required for identifying which GPS satellite corresponds to the code C1. Thus, the terminal 20 may integrate the sampling results of the code C1 and the replica codes C1-1 and the like required for extracting the code C1 without restrictions imposed by transmission interval period of the codes C1 and the like.

This allows the terminal 20 to integrate the number of times required for extracting the codes C1 and the like without restrictions imposed by transmission interval period of the codes C1 and the like.

The terminal 20 also generates the replica codes C1-1 and the like so that the total number of the code C1 and the replica codes C1-1 and the like equals the number required for identifying which GPS satellite corresponds to the code C1.

This allows the terminal 20 to generate the sufficient number of replica codes C1-1 and the like required for identifying which GPS satellite corresponds to the code C1.

The terminal 20 also generates the replica codes C1-1 and the like within a range of delay in which the base band section 34 can identify the chips P1 and the like which are standard units configuring the code C1. In order to identify which GPS satellite corresponds to the code C1 or the like, the chips P1 and the like allocated at the identical position in the code C1 and the replica codes C1-1 and the like must be integrated with each other.

The terminal 20 generates the replica codes C1-1 and the like within a range of delay in which the base band section 34 can identify which GPS satellite corresponds to the code C1 or the like. Accordingly, the base band section 34 can identify which GPS satellite corresponds to the code C1 reliably.

The terminal 20 also generates the replica codes C1-1 and the like with respect to a part of the code C1 or the like.

As described above, it is possible to identify which GPS satellite corresponds to the code C1 by sampling only a part of the code C1, not all of-the code C1.

The terminal 20 generates the replica codes C1-1 and the like with respect to a part of the code C1 or the like. This allows the terminal 20 to reduce the sampling time and identify which GPS satellite corresponds to the code C1 or the like.

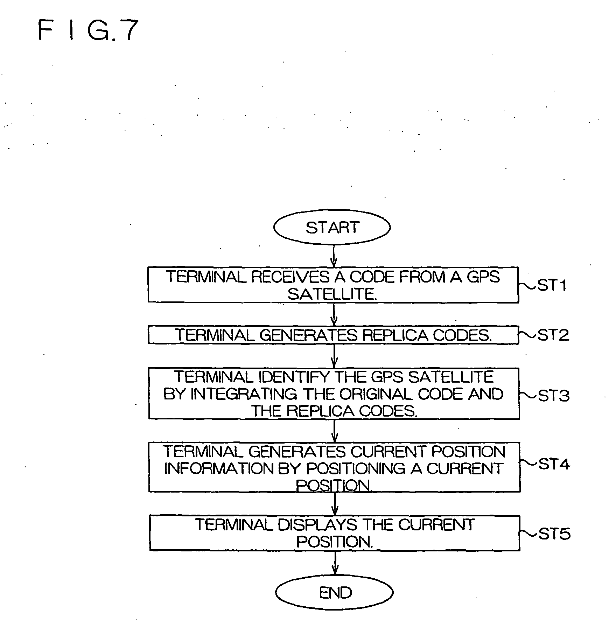

The structure of the terminal 20 in the embodiment is described above. The operation example is hereinafter described mainly using Fig. 7.

Fig. 7 schematically illustrates a flowchart of an operation example of the terminal 20.

First, the terminal 20 receives a C/A code C1 putted on the radio wave S1 from the GPS satellite 12a, for example (step ST1 in Fig. 7).

Subsequently, the terminal 20 generates the replica codes C1-1 and the like (see Fig. 3 (c)) (step ST2). The step ST2 is an example of the analysis assistance code generating step.

Afterwards, the terminal 20 integrates the original code C1 and the replica codes C1-1 and the like, and identifies which GPS satellite corresponds to the code C1 (step ST3). The step ST3 is an example of the positioning standard code identifying step.

The terminal 20 then positions a current position, and generates the current position information 158 (see Fig. 6) (step ST4). The step ST4 is an example of the current position information generating step.

Next, the terminal 20 displays the current position information 158 on the display apparatus 38 (see Fig. 5) (step ST5).

As mentioned above, the terminal 20 can integrate the number of times required for extracting the codes C1 and the like without restrictions imposed by transmission interval period of the codes C1 and the like.

### Modified Example of the Embodiment

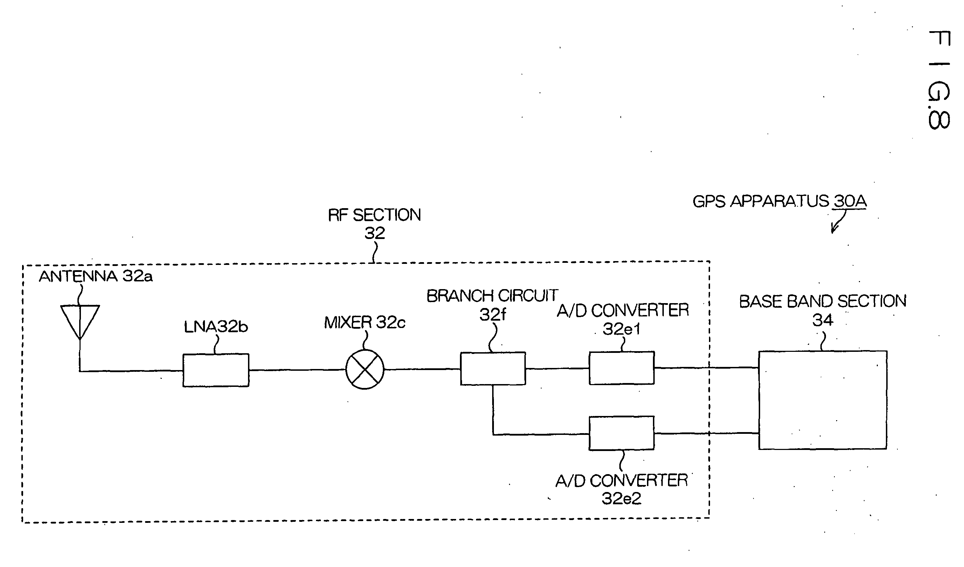

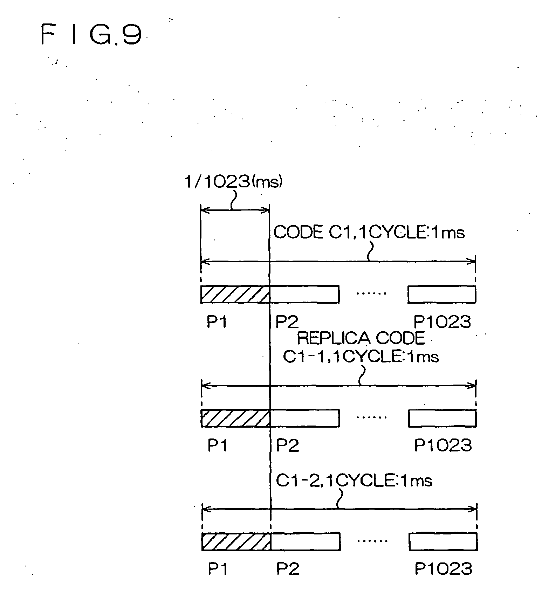

Next, the modified example of the embodiment is described mainly using Figs. 8 and 9.

Fig. 8 schematically illustrates a structure of a GPS apparatus 30A in the modified example of the embodiment.

Fig. 9 schematically illustrates codes C1 and the like.

As illustrated in Fig. 8, the GPS apparatus 30A includes a branch circuit 32f.

As illustrated in Fig. 9, the branch circuit 32f generates replica codes C1-1 and C1-2 without delay with respect to the code C1.

This allows a base band section 34 to receive the code C1 and the replica codes C1-1 and C1-2 simultaneously. Accordingly, the base band section 34 takes only 1/1023 msec (ms) to receive the respective chips P1 in the code C1 and the replica codes C1-1 and C1-2. The base band section 34 can execute sampling for the respective chips P1 in the code C1 and the replica codes C1-1 and C1-2 at once.

If we receive the C/A code three times, and receive the respective chips P1 three times, for example, it takes (2+1/1023) msec (ms) to, as described above.

On the other hand, according to this embodiment, the base band section 34 takes extremely shorter time, only 1/1023 msec (ms) to receive and sample the replica codes C1-1 and C1-2 after receiving the code C1.

The present invention is not limited to the above-described respective embodiments. Further, the above-described respective embodiments may be combined with each other.

## Claims

1. A positioning apparatus (30) for receiving a positioning standard code (C1) which is used as a standard of positioning from a positioning satellite (12a), the apparatus (30) **characterized in** comprising:
analysis assistance code generating means (32d; 32f) for generating a plurality of analysis assistance codes (C1-1, C1-2) comprising replicas of a received positioning standard code (C1) for use in determining which positioning satellite corresponds to the received positioning standard code (C1);
positioning standard code identifying means (34) for analyzing the positioning standard code (C1) and the analysis assistance codes (C1-1, C1-2), and identifying which positioning satellite corresponds to the positioning standard code (C1), the positioning standard code identifying means (34) comprising:
means for integrating the received positioning standard code (C1) and the plurality of generated analysis assistance codes (C1-1, C1-2) to generate an integrated result; and
means for correlating the integrated result with a plurality of stored C/A codes to identify which positioning satellite corresponds to the received positioning standard code (C1); and
current position information generating means (100, 114) for generating current position information indicating a current position based on the identified result by the positioning standard code identifying means.

2. The positioning apparatus of claim 1, wherein the analysis assistance code generating means (32d; 32f) is arranged to generate the analysis assistance codes (C1-1, C1-2) so that the total number of the positioning standard code (C1) and the analysis assistance codes (C1-1, C1-2) equals the number required for identifying which positioning satellite corresponds to the positioning standard code (C1).

3. The positioning apparatus of any of claims 1 and 2, wherein the analysis assistance code generating means (32d; 32f) is arranged to generate the analysis assistance codes (C1-1, C1-2) within a range of delay in which the positioning standard code identifying means (34) can identify standard unit code, which is a standard unit configuring the positioning standard code (C1).

4. The positioning apparatus of any of claims 1 through 3, wherein the analysis assistance code generating means (32d; 32f) is arranged to generate the analysis assistance codes (C1-1, C1-2) with respect to a part of the positioning standard code (C1).

5. A positioning method, for receiving a positioning standard code (C1) which is used as a standard of positioning from a positioning satellite (12a), the method **characterized in** comprising:
an analysis assistance code generating step (ST2) in which a positioning apparatus (30) generates a plurality of analysis assistance codes (C1-1, C1-2) comprising replicas of a received positioning standard code (C1) for use in determining which positioning satellite corresponds to the received positioning standard code (C1);
a positioning standard code identifying step (ST3) in which the positioning apparatus (30) analyzes the positioning standard code (C1) and the analysis assistance codes (C1-1, C1-2), and identifies which positioning satellite corresponds to the positioning standard code (C1), the positioning standard code identifying step comprising:
integrating the received positioning standard code (C1) and the plurality of generated analysis assistance codes (C1-1, C1-2) to generate an integrated result; and
correlating the integrated result with a plurality of stored C/A codes to identify which positioning satellite corresponds to the received positioning standard code (C1); and
a current position information generating step (ST4) in which the positioning apparatus (30) generates current position information indicating a current position based on the identified result by the positioning standard code identifying step.

## Patentansprüche

1. Eine Positionierungsvorrichtung (30) zum Empfangen eines Positionierungsstandardcodes (C1), der als ein Standard zur Positionierung von einem Positionierungssatelliten (12a) verwendet wird, die Vorrichtung (30) **gekennzeichnet** zu umfassen:
ein Analyseunterstützungscodegenerierungsmittel (32d; 32f) zum Generieren einer Vielzahl von Analyseunterstützungscodes (C1-1, C1-2), die Replika eines empfangenen Positionierungsstandardcodes (C1) umfassen zur Verwendung bei einer Bestimmung, welcher Positionierungssatellit dem empfangenen Positionierungsstandardcode (C1) entspricht;
ein Positionierungsstandardcode-Identifikationsmittel (34) zum Analysieren des Positionierungsstandardcodes (C1) und der Analyseunterstützungscodes (C1-1, C1-2), und Identifizieren, welcher Positionierungssatellit dem Positionierungsstandardcode (C1) entspricht, wobei das Positionierungsstandardcode-Identifikationsmittel (34) umfasst:
ein Mittel zum Integrieren des empfangenen Positionierungsstandardcodes (C1) und der Vielzahl von generierten Analyseunterstützungscodes (C1-1, C1-2), um ein integriertes Ergebnis zu generieren; und
ein Mittel zum Korrelieren des integrierten Ergebnisses mit einer Vielzahl von gespeicherten C/A-Codes um zu identifizieren, welcher Positionierungssatellit dem empfangenen Positionierungsstandardcode (C1) entspricht; und
ein Generierungsmittel aktueller Positionsinformation (100, 114) zum Generieren aktueller Positionsinformation, die eine aktuelle Position anzeigt basierend auf dem identifizierten Ergebnis durch das Positionierungsstandardcode-Identifikationsmittel.

2. Die Positionierungsvorrichtung nach Anspruch 1, wobei das Analyseunterstützungscode-Generierungsmittel (32d; 32f) angeordnet ist, die Analyseunterstützungscodes (C1-1, C1-2) zu generieren, sodass die Gesamtzahl des Positionierungsstandardcodes (C1) und der Analyseunterstützungscodes (C1-1, C1-2) gleich der Zahl ist, die zum Identifizieren erforderlich ist, welcher Positionierungssatellit dem Positionierungsstandardcode (C1) entspricht.

3. Die Positionierungsvorrichtung nach beliebigen von Ansprüchen 1 und 2, wobei das Analyseunterstützungscode-Generierungsmittel (32d; 32f) angeordnet ist, die Analyseunterstützungscodes (C1-1, C1-2) innerhalb eines Bereiches einer Verzögerung zu generieren, worin das Positionierungsstandardcode-Identifikationsmittel (34) einen Standardeinheitencode identifizieren kann, der eine Standardeinheit ist, die den Positionierungsstandardcode (C1) konfiguriert.

4. Die Positionierungsvorrichtung nach beliebigen von Ansprüchen 1 bis 3, wobei das Analyseunterstützungscode-Generierungsmittel (32d; 32f) angeordnet ist, die Analyseunterstützungscodes (C1-1, C1-2) mit Bezug auf einen Teil des Positionierungsstandardcodes (C1) zu generieren.

5. Ein Positionierungsverfahren zum Empfangen eines Positionierungsstandardcodes (C1), der als ein Standard verwendet wird zum Positionieren von einem Positionierungssatelliten (12a), das Verfahren **gekennzeichnet** zu umfassen:
einen Analyseunterstützungscode-Generierungsschritt (ST2), in dem eine Positionierungsvorrichtung (30) eine Vielzahl von Analyseunterstützungscodes (C1-1, C1-2) generiert, umfassend Replika eines empfangenen Positionierungsstandardcodes (C1) zur Verwendung bei einer Bestimmung, welcher Positionierungssatellit dem empfangenen Positionierungsstandardcode (C1) entspricht;
einen Positionierungsstandardcode-Identifikationsschritt (ST3), in dem die Positionierungsvorrichtung (30) den Positionierungsstandardcode (C1) und die Analyseunterstützungscodes (C1-1, C1-2) analysiert, und identifiziert, welcher Positionierungssatellit dem Positionierungsstandardcode (C1) entspricht, wobei der Positionierungsstandardcode-Identifikationsschritt umfasst:
Integrieren des empfangenen Positionierungsstandardcodes (C1) und der Vielzahl von generierten Analyseunterstützungscodes (C1-1, C1-2), um ein integriertes Ergebnis zu generieren; und
Korrelieren des integrierten Ergebnisses mit einer Vielzahl von gespeicherten C/A-Codes um zu identifizieren, welcher Positionierungssatellit dem empfangenen Positionierungsstandardcode (C1) entspricht; und
einen Generierungsschritt aktueller Positionsinformation (ST4), in dem die Positionierungsvorrichtung (30) aktuelle Positionsinformation generiert, die eine aktuelle Position anzeigt basierend auf dem identifizierten Ergebnis durch den Positionierungsstandardcode-Identifikationsschritt.

## Revendications

1. Appareil de positionnement (30) pour recevoir un code standard de positionnement (C1) qui est utilisé comme critère de positionnement par rapport à un satellite de positionnement (12a), l'appareil (30) étant **caractérisé par** le fait de comprendre :
un moyen générant des codes d'aide à l'analyse (32d ; 32f) pour générer une pluralité de codes d'aide à l'analyse (C1-1, C1-2) comprenant des copies d'un code standard de positionnement reçu (C1) pour une utilisation dans la détermination de savoir quel satellite de positionnement correspond au code standard de positionnement reçu (C1) ;
un moyen d'identification du code standard de positionnement (34) pour analyser le code standard de positionnement (C1) et les codes d'aide à l'analyse (C1-1, C1-2) et pour identifier quel satellite de positionnement correspond au code standard de positionnement (C1), le moyen d'identification du code standard de positionnement (34) comprenant :
un moyen pour intégrer le code standard de positionnement reçu (C1) et la pluralité de codes d'aide à l'analyse générés (C1-1, C1-2) pour générer un résultat intégré ; et
un moyen pour corréler le résultat intégré avec une pluralité de codes C/A conservés pour identifier quel satellite de positionnement correspond au code standard de positionnement reçu (C1) ; et
un moyen générant des informations sur la position actuelle (100, 114) pour générer des informations sur la position actuelle indiquant une position actuelle sur la base du résultat identifié par le moyen d'identification du code standard de positionnement.

2. Appareil de positionnement selon la revendication 1, dans lequel le moyen générant des codes d'aide à l'analyse (32d ; 32f) est arrangé pour générer les codes d'aide à l'analyse (C1-1, C1-2) de telle sorte que le nombre total de codes standard de positionnement et de codes d'aide à l'analyse (C1-1, C1-2) est égal au nombre requis pour identifier quel satellite de positionnement correspond au code standard de positionnement (C1).

3. Appareil de positionnement selon n'importe laquelle des revendications 1 et 2, dans lequel le moyen générant des codes d'aide à l'analyse (32d; 32f) est arrangé pour générer les codes d'aide à l'analyse (C1-1, C1-2) dans une plage de retard dans laquelle le moyen d'identification du code standard de positionnement (34) peut identifier un code d'unité standard qui est une unité standard configurant le code standard de positionnement (C1).

4. Appareil de positionnement selon n'importe laquelle des revendications 1 à 3, dans lequel le moyen générant des codes d'aide à l'analyse (32d ; 32f) est arrangé pour générer les codes d'aide à l'analyse (C1-1, C1-2) en ce qui concerne une partie du code standard de positionnement (C1).

5. Procédé de positionnement pour recevoir un code standard de positionnement (C1) qui est utilisé comme critère de positionnement par rapport à un satellite de positionnement (12a), le procédé étant **caractérisé par** le fait de comprendre :
une étape de génération des codes d'aide à l'analyse (ST2) dans laquelle un appareil de positionnement (30) génère une pluralité de codes d'aide à l'analyse (C1-1, C1-2) comprenant des copies d'un code standard de positionnement reçu (C1) pour une utilisation dans la détermination de savoir quel satellite de positionnement correspond au code standard de positionnement reçu (C1) ;
une étape d'identification du code standard de positionnement (ST3) dans laquelle l'appareil de positionnement (30) analyse le code standard de positionnement (C1) et les codes d'aide à l'analyse (C1-1, C1-2) et identifie quel satellite de positionnement correspond au code standard de positionnement (C1), l'étape d'identification du code standard de positionnement comprenant les étapes consistant à :
intégrer le code standard de positionnement reçu (C1) et la pluralité de codes d'aide à l'analyse générés (C1-1, C1-2) pour générer un résultat intégré ; et
corréler le résultat intégré avec une pluralité de codes C/A conservés pour identifier quel satellite de positionnement correspond au code standard de positionnement reçu (C1) ; et
une étape générant des informations sur la position actuelle (ST4) dans laquelle l'appareil de positionnement (30) génère des informations sur la position actuelle indiquant une position actuelle sur la base du résultat identifié par l'étape d'identification du code standard de positionnement.
